Europäisches Patentamt

European Patent Office

Office européen des brevets

(19)

(11) Publication number: **0 078 347**
**A1**

# EUROPEAN PATENT APPLICATION

(12)

(21) Application number: 81201204.5

(22) Date of filing: 29.10.81

(51) Int. Cl.³: **H 03 F 3/45**

(43) Date of publication of application: **11.05.83**
**Bulletin 83/19**

(84) Designated Contracting States: **AT BE CH DE FR GB IT LI LU NL SE**

(71) Applicant: **BELL TELEPHONE MANUFACTURING COMPANY Naamloze Vennootschap, Francis Wellesplein 1, B-2000 Antwerp (BE)**

(84) Designated Contracting States: **BE LU NL**

(71) Applicant: **International Standard Electric Corporation, 320 Park Avenue, New York New York 10022 (US)**

(84) Designated Contracting States: **CH DE FR GB IT LI SE AT**

(72) Inventor: **Danneels, Johan Maurits Raphael, Nieuwstraat 101, B-2628 Rupelmonde (BE)**
Inventor: **Van den Bossche, Luc Jozef Louis, Korte Moerstraat 18, B-9330 Dendermonde (BE)**

(74) Representative: **Vermeersch, Robert et al, BELL TELEPHONE MANUFACTURING COMPANY Naamloze Vennootschap Patent Department Francis Wellesplein 1, B-2000 Antwerp (BE)**

(54) Telecommunication line high-efficiency operational amplifier.

(57) Telecommunication line circuit includes two line driver feedback amplifier circuits (OA1, OA2) connected to first and second conductors of a telecommunication line (L) and fed via a gating circuit (PC) by a common variable line length dependent (DC) supply voltage provided by a line loop current control circuit sensing the voltage drop across the line loop resistors (RL1, RL2) and thus sensing the line length. Each line driver amplifier (OA1, OA2) circuit is a differential amplifier circuit including a differential-to-single-ended stage (S1), an intermediate stage (S2) and an output stage (S3). The differential-to-single-ended stage (S1) has a low input impedance and includes a slew rate circuit with two cross-coupled cascode circuits (Q29–Q32) providing a high output impedance. The output stage (S3) is a class B emitter follower stage including a current deviation circuit (38, 39) which decreases the power consumption when the line loop is open. In this case the gating circuit (PC) only connects the supply voltage (D+, D−) to the output stage.

-1-

## Amplifiers, gating circuit and telecommunication line circuit using same.

The invention relates to a differential amplifier circuit, e.g. an operational amplifier, including a differential-to-single-ended amplification stage comprising cross-coupled first and second amplification circuits.

Such a differential amplifier circuit is known from the book : "201 Analog IC designs compiled, tested and written by the staff of Interdesign (Ferranti), Sunnydale, California, 1980". On page 18, Fig. 42 there is shown an operational amplifier which includes a differential-to-single-ended amplification stage the amplification circuits of which are Darlington voltage follower circuits cross-coupled via the emitter-base circuits of transistors. The collectors of these transistors are connected to a differential-to-single-ended conversion active load circuit whose output is coupled to a further amplification stage having a capacitive input. More particularly, this further amplification stage includes a further transistor the collector-base circuit of which is coupled in parallel with a capacitor producing said capacitive input by Miller effect.

The open loop (forward) gain versus frequency curve of an amplifier circuit can be adequately represented by using Bode's asymptotic approximations and consists of a number of

0078347

-2-

successive straight line segments, the first one at the lower frequencies having a zero slope whereas each of the following segments has a slope of -20 dB per decade more than the previous one. Two succeeding segments intersect at a pole frequency and each pole decreases the slope of the open loop phase shift versus frequency response characteristic by 45° per decade for a frequency decade above and below each pole frequency, so that each such pole adds -90° to the overall negative phase shift, say F. In an amplifier circuit with feedback instability occurs when the loop gain which is the product of the feedback factor and the open (forward) loop gain equals minus one, i.e. when simultaneously the phase shift reaches -180° and the magnitude of the loop gain is equal to one. To examine the stability ofsuch a feedback amplifier it is therefore necessary to consider the phase margin, i.e. the phase shift 180° + F, at the particular frequency where the above magnitude of the loop gain is unity. In the open loop gain versus frequency curve this particular frequency is that of the intersection point of the curve with the reciprocal of the feedback factor.

To increase the stability of an amplifier one may shift the first pole into the direction of the lower frequencies as this increases the phase margin, the bandwidth being however reduced. For a predetermined input impedance of the input stage, a sufficiently low frequency of the first pole can be obtained by a suitably high value of the above mentioned, i.e. compensation, capacitor. However, the capacitor value cannot be chosen unduly large because it limits the slew rate or rise time of the amplifier.

A first object of the present invention is to provide a differential amplifier circuit of the above type and the stability of which can be increased without affecting its slew rate.

-3-

According to the invention this object is achieved due to the fact that said cross-coupled first and second amplification circuits include first and second cascode circuits respectively.

Due to the high impedance provided by each of the cascode circuits the differential-to-single-ended amplification stage has a high output impedance and this has for effect that the first pole of the open loop versus frequency curve is shifted into the direction of the lower frequencies, thus increasing the stability without affecting the slew rate of the amplifier circuit.

The amplifier circuit most difficult to compensate is a unity gain amplifier, i.e. an amplifier having a feedback factor equal to unity. Indeed, because the reciprocal of this feedback factor is also equal to one the phase margin is obtained by considering the intersection point of the open loop gain with the frequency axis. This phase margin is insufficient from a viewpoint of stability because each of the poles located above the frequency axis adds $-90°$ to the overall phase shift. To increase the phase margin to a sufficiently high value it is therefore indicated to shift the second pole below the frequency axis and into the direction of the higher frequencies. Thus also a relatively high unity gain bandwidth is obtained.

Another object of the present invention is to provide a differential amplifier circuit wherein the second pole is shifted, in the open loop gain versus frequency curve, below the frequency axis and into the direction of the higher frequencies.

According to the invention this object is achieved due to the fact that said differential-to-single-ended amplification stage has a low input impedance.

-4-

By the low input impedance the second pole is indeed shifted below the frequency axis and in the direction of the higher frequencies.

Another characteristic feature of the present differential amplifier circuit is that it further includes an intermediate amplification stage and an class B emitter follower output amplification stage which are coupled in cascade between said output terminal of said differential-to-single-ended amplification stage and an electric load.

The present invention also relates to a power amplifier circuit connected in class B emitter follower configuration and having a single AC/DC signal input terminal and a common terminal which is coupled to a load, said power amplifier circuit being fed from a DC voltage source and including two emitter follower amplification circuits each branched between said common terminal and a distinct pole of said DC voltage source, individual input terminals of said amplification circuits being intercoupled by two series connected fourth diodes fed from a DC current source and one of said individual input terminals constituting said single input terminal, each of said amplification circuits including an output fourth transistor and the collector-to-emitter paths of said output fourth transistors being interconnected in series and connected to said common terminal.

Such an amplifier circuit is already known from the book "Analysis and design of analog integrated circuits" by P.R. Gray et al, John Wiley & Sons, and is shown on page 303 thereof.

A further object of the present invention is to provide a power amplifier circuit of the above type but the electric power consumption of which can be regulated in function of the

-5-

impedance of the electric load.

According to the invention this object is achieved due to the fact that in each of said emitter follower amplification circuits an output signal of said output fourth transistor controls an associated individual current deviation means in such a way that when said load has a lower impedance value no current is deviated from said individual input terminal, whereas when said load has a higher impedance value current is deviated from said individual input terminal.

Such a power amplifier is particularly useful in a telecommunication line circuit wherein the variable electric load is constituted by a telecommunication line coupled to the line circuit. Indeed, in this way the power consumption of the amplifier is considerably reduced during the time the line loop is open, i.e. when the impedance of the electric load is high.

Another feature of the present invention is that a power amplifier circuit just defined is used as the class B emitter follower output amplification stage forming part of the above described differential amplifier circuit.

Still another feature of the present invention is that in said differential amplifier circuit said input, differential-to-single-ended and intermediate amplification stages are able to be fed from the first mentioned DC voltage source and from a second DC current source, whereas said output amplification stage is continuously fed from said first mentioned DC voltage source and able to be fed from said first mentioned current source or from said second current source, and that a gating circuit is provided in order when the impedance of said electric load has said higher value to disconnect said first mentioned DC voltage source and said second current source from said input, differential-to-single-ended and intermediate amplification stages and to connect said first current source to said output amplification stage and in order when the impedance of said electric load has said lower value to connect said second DC voltage source and said second current source to all the amplification stages and to disconnect said first mentioned current source from said output amplification stage.

The present invention also relates to a gating circuit having a control terminal to which a control signal provided by a control system is applied.

Still another object of the present invention is to provide a gating circuit of this type which is adapted to be used in the differential amplifier circuit just defined, more particularly but not exclusively.
According to the invention a characteristic feature of this gating circuit is that it includes a third and a fourth DC current sources which are both fed from a first DC voltage source, said third current source being controlled by said control signal and said third and fourth current sources being intercoupled in such a way that for one condition of said control signal said third DC current source is operated and thereby inhibits the operation of said fourth current source, whereas for the other condition of said control signal said third current source is not operated and said fourth current source is operated.

The present invention finally also relates to a telecommunication line circuit including two line driver feedback amplifier circuits which are connected to first and second conductors of a telecommunication line respectively.

Such a telecommunication line circuit is already known from UK patent application 2.050.115. Therein the electric power

-7-

consumption of each line driver amplifier circuit is maintained at a sufficiently low value, to permit this amplifier circuit to be integrated, by making use of an additional DC current injection circuit able to directly inject current on the line.

Yet another object of the present invention is to provide a telecommunication line circuit of the above type, but wherein the electric power consumption of each of the line driver amplifier circuits is regulated, without requiring the use of such an additional circuit, in such a way that these circuits can be integrated.

According to the invention this object is achieved due to the fact that each of said line driver feedback amplifier circuits is fed from a first DC voltage source providing a variable first DC supply voltage which is function of the length of said line.

Because the power consumption of each of the line driver amplifier circuits is function of the DC supply voltage applied thereat by the first DC voltage source, it is clear that also this power consumption is function of the line length. More particularly it is reduced for shorter line lengths.

According to a preferred embodiment the line circuit of the present invention includes two line driver feedback amplifier circuits connected to first and second conductors of a telephone line and fed via a gating circuit by a common variable line length dependent DC supply voltage provided by a line loop current control circuit sensing the voltage drop across the line loop resistors and thus sensing the line length. Each line driver amplifier circuit is a differential amplifier circuit including the cascade connection of a differential input stage, a differential-to-single-ended stage, an intermediate stage and an output stage. The differentiel-to-single-
ended stage has a low input impedance and includes a slew
rate circuit with two cross-coupled cascode circuits providing
a high output impedance and a differential-to-single-ended
conversion high impedance stage. The output stage is a class
B emitter follower stage including a current deviation circuit
which is only operative when the line loop is open, thus
decreasing the electric power consumption in this condition.
To further reduce the electric power consumption in case the
line loop is open the gating circuit then disconnects the
above variable DC supply voltage from all stages but the output
stage of the amplifier. It then also disconnects a current
source from all the stages of the amplifier and connects
another current source only to the output stage thereof.

The above mentioned and other objects and features of the
invention will become more apparent and the invention itself
will be best understood by referring to the following
description of an embodiment taken in conjunction with the
accompanying drawings wherein;

Fig. 1 shows a detailed circuit of a differential
amplifier circuit according to the invention;

Fig. 2 is a general block diagram showing a control
system with feedback;

Fig. 3 is an open loop gain magnitude versus
frequency response curve of an amplifier circuit;

Fig. 4 is a phase versus frequency response curve of
an amplifier circuit;

Fig. 5 is an open loop gain magnitude versus
frequency response curve of the amplifier circuit
of Fig. 1;

-9-

Figs. 6 and 7 when juxtaposed, with Fig. 7 on the right, show part of a telephone line circuit according to the invention.

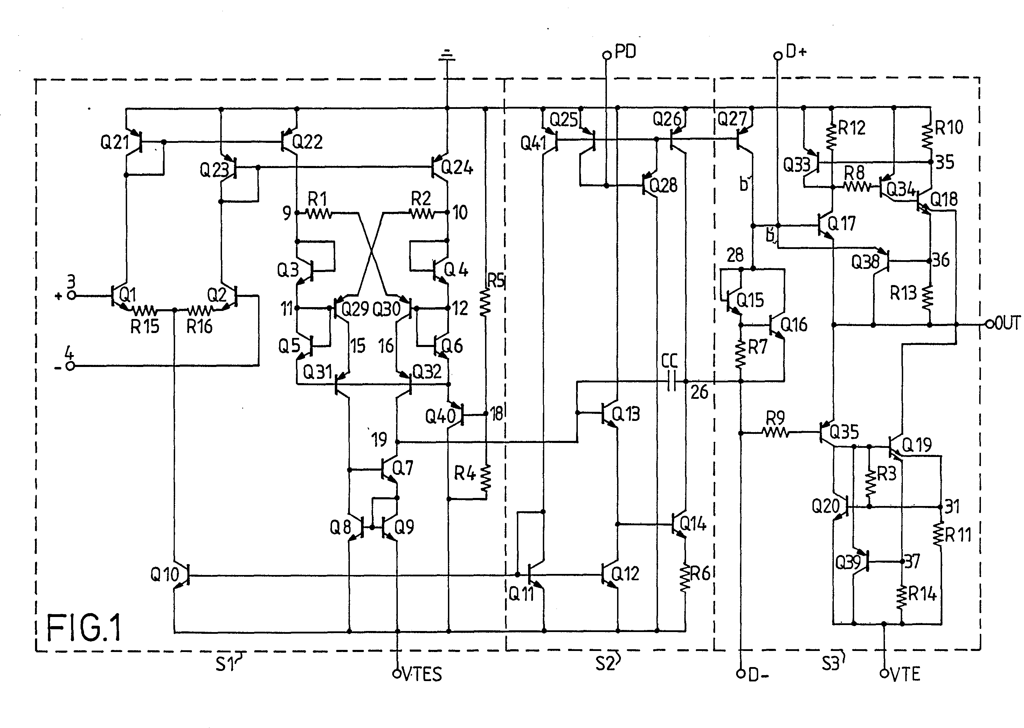

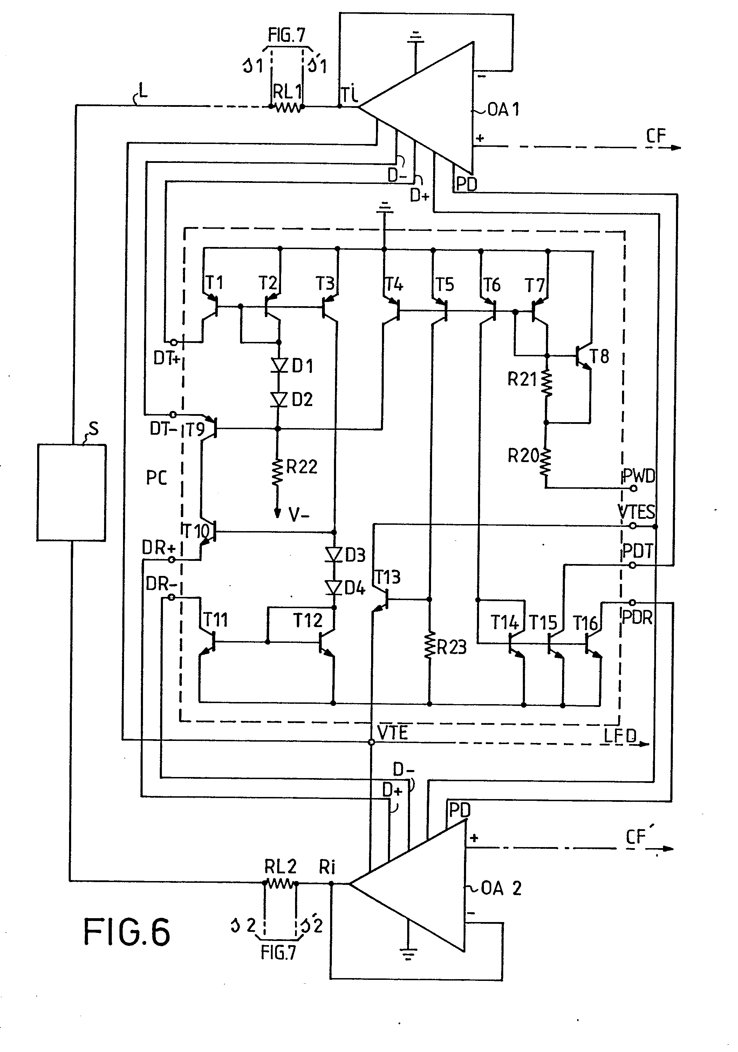

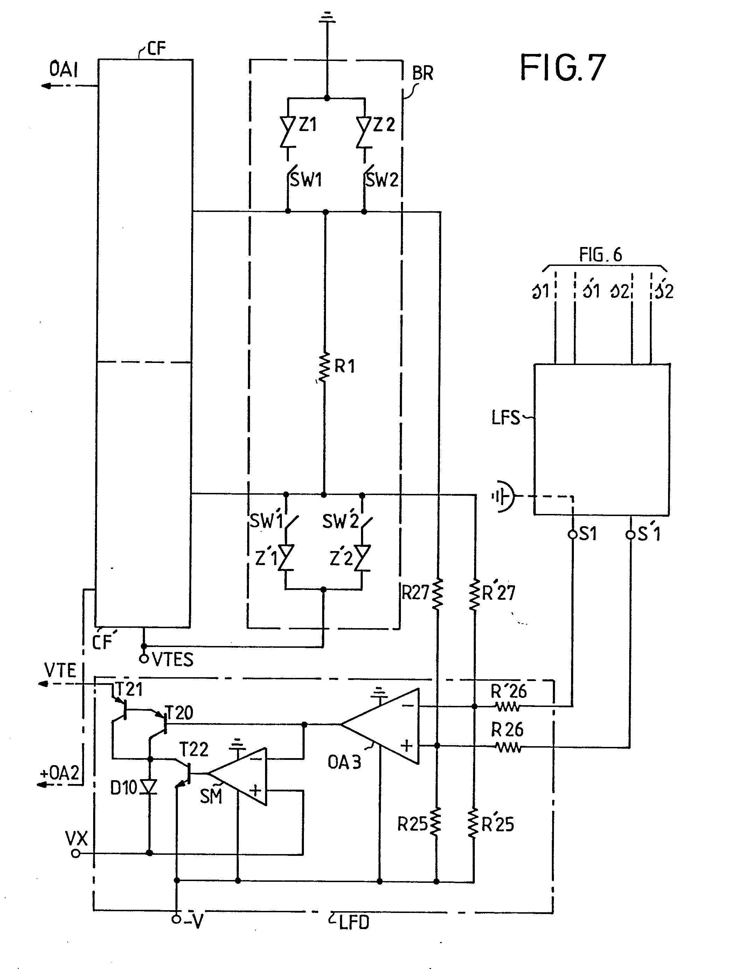

Referring to Fig. 1 the differential amplifier shown therein includes three stages : an input and differential-to-single-ended stage S1, a buffering intermediate stage S2 and an ouput power stage S3. The intermediate and the output stage of the amplifier which is grounded may receive supply voltages VTES and VTE via corresponding terminals of a gating circuit PC which is shown in Fig. 6 and which will be described in detail later. This gating circuit is able to supply both these voltages and to sink a constant current via terminal PD during the so-called power on state when all the stages receive power or to only supply the voltage VTE and a constant current via terminals D +, D - to the output stage during the reduced power state or the so-called power down state.

The input and differential-to-single-ended stage S1 includes a differential input stage with emitter coupled transistors Q1 and Q2 and a differential-to-single-ended stage mainly including a slew rate circuit comprising transistors Q29, Q30, Q31, Q32 and a differential-to-single ended conversion high impedance stage including transistors Q7, Q8, Q9. The slew rate of a stage, generally expressed in Volts per microsecond is the rate of change of the output voltage for a corresponding input voltage and this slew rate is limited by the current available to charge circuit capacitors, e.g. compensation capacitors used to increase the stability of the amplifier as will be explained later. The emitter coupled transistors Q1 and Q2 the bases of which are connected to input terminals 3 and 4 are current sources biased by transistor Q10 for common mode rejection. Q10 forms part of a current source including also transistors Q11 and Q12. The collector of transistor Q11 is connected to the collector of transistor

-10-

Q41 having its base interconnected with transistors Q25 and Q26 forming part of the intermediate stage and transistor Q27 of the output stage. The base currents of these transistors flow via the emitter-collector circuit of transistor Q28, the base current of which is sunk by a current source of the gating circuit PC via terminal PD (Fig. 6) as will be described in detail later. Common mode rejection circuits for emitter coupled pairs are for instance described on pages 217 and 218 of the book : "Analysis and design of analog integrated circuits" by P.R. Gray and R.G. Meyer, edited by John Wiley & Sons, New York.

Transistors Q1 and Q2 both have an active load constituted by transistors Q21 and Q23 which form part of mirror circuits including the mirror transistors Q22 and Q24 respectively. The collector currents of transistors Q1 and Q2 are thus mirrored into the corresponding branches of the slew rate circuit by means of the above mirror transistors.

The slew rate circuit includes the above mentioned cross-coupled transistors Q29, Q30 forming a cascade connection with transistors Q31, Q32 respectively, and an active load also used as a differential-to-single-ended conversion high impedance stage including transistors Q8, Q9 and Q7. More information concerning active loads and circuits for improving the slew rate can also be found on pages 211 to 267 and 541 to 551 of the above mentioned book by P.R. Gray and R.G. Meyer respectively. In the article "An input stage transconductance reduction technique for high-slew rate operational amplifiers" by J.C. Schmoock published on pages 407 to 411 of the IEEE Journal of solid-state circuits, Vol. SC 10 N° 6, December 1975 and on page 18 of the book "201 Analog IC designs compiled, tested and written by the staff of Interdesign Incorporated Sunnydale California, 1980" circuit N° 42 improved slew rate circuits with an active load used for the differential-to-single-ended conversion are shown and more information on the operation of

-11-

such slew rate circuits can be found therein. In these circuits use is made of cross coupled transistors in order to reduce the transconductance, i.e. the variation of the output current with respect to the input voltages, of this stage to increase the slew rate. In the slew rate circuit of the present invention the bases of transistors Q29, Q31 and Q30, Q32 are bridged by means of diodes Q5 and Q6 respectively. Diodes Q3 and Q4 interconnect junction points 9 and 10 of the collectors of Q22 and Q24 and resistors R1 and R2 with the bases 11 and 12 of transistors Q29 and Q30 respectively. Resistors R1 and R2 are degeneration resistors used to increase the slew rate. Such degeneration resistance are shown on page 410 of the above mentioned article. Both bases of transistors Q31, Q32 and emitter of a grounded collector transistor Q40 are interconnected. The base of Q40 is connected to junction point 18 of the potentiometer circuit including resistors R4 and R5 connected between ground and the supply voltage VTES. In this way the bias voltages of transistors Q31, Q32 and Q29, Q30 are not floating and are one and two diode voltage drops higher than the voltage of junction point 18 respectively. The series connected diodes Q3, Q5 and Q4, Q6 connected to the emitter of grounded collector transistor Q40 form a low impedance output load for the differential input stage. Also, the impedance seen at the junction point 19 is high due to presence of the cascode configuration including transistors Q32 and Q31 and to the differential-to-single-ended conversion high impedance stage. The combination of this low and high impedance in the slew rate circuit increases the stability of the operational amplifier as will be explained in more detail later.

The intermediate stage includes emitter follower Q13, and amplifier Q14. The active load of transistor Q13 is constituted by the collector-emitter circuit of transistor Q12 which forms part of the current source including transistors Q10 and Q11

-12-

the base coupled transistors Q25, Q26, Q27 and Q41 and transistor Q28. The base of this transistor and collector of transistor Q25 are connected to PD which is connected to terminal PDR for instance of the gating circuit PC (Fig. 6) this gating circuit PC sinks a constant current via this terminal PDR as mentioned earlier. In this way, the current in the current source of the intermediate stage S2 will be constant, independelty of the supply voltage value VTES. If this precaution were not taken the current in the current sources may then change in function of the VTES value and this would cause impedance changes and instabilities of the amplifier. VTES is made to change when this amplifier is used for instance as a line driver operational amplifier in telephony where VTES is varied in function of the line length. For small line lengths the supply voltages VTES and VTE are reduced to reduce the power dissipation of the amplifier.

The base of transistor Q13 is connected to the collector of transistor Q14 via capacitor CC. This feedback capacitor is known in the art as a compensation capacitor and improves the stability of the amplifier because it provides phase compensation through Miller-effect multiplication. More information concerning phase compensation of amplifiers can be found in Chapter 5 pages 165 to 197 of the book "Operational amplifiers, design and applications" by J.G. Graeme, G.E. Tobey and L.P. Huelsman, edited by Mc Graw-Hill Book Company, New York and on pages 512 to 521 of the above mentioned book by P.R. Gray and R.G. Meyer. However, it has been found that the addition of such a capacitor do not assure complete stability of the present amplifier, this being mainly due to the addition of an output power stage, to be described later, and which creates additional poles. Therefore, supplementary measures have been taken such as the introduction of cascode transistors and shunting diodes in the slew rate circuit as mentioned earlier.

-13-

To more easily understand how this slew rate circuit improves the stability, it will be usefull to recall briefly some fundamental properties concerning the stability problem of an amplifier in general.

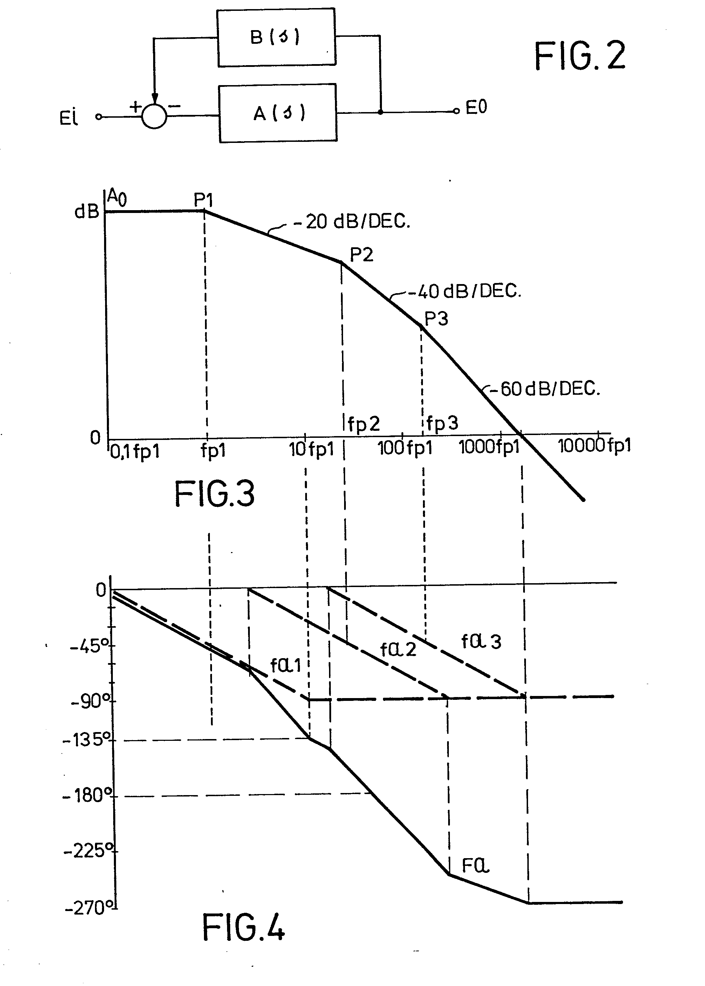

1) reference is made to Fig. 2. The closed-loop gain of an amplifier is

$$Acl\ (s) = \frac{E_o}{E_i} = \frac{A(s)}{1 + A(s)\ .\ B(s)}$$

wherein   s   is a complex variable

$E_o$ and $E_i$   are input and output signals respectively

A(s)   is the open-loop gain of the amplifier

B(s)  is the feedback factor

A(s) . B(s) can be defined as the loop gain

Instability occurs when A(s) . B(s) = -1

or when $|A|$ . $|B|$ = 1 and Fa + Fb = -180°

wherein $|A|$ , $|B|$ and Fa, Fb are the moduli and phases of the complex numbers A and B respectively.

The quantity 180° + (Fa + Fb) at the frequency where $|A|$ . $|B|$ = 1 is called the phase margin. The stability of an amplifier, e.g. an operational amplifier, can be examined by determing the phase margin at the intersection point of the open-loop gain response curve (gain magnitude) and $\frac{1}{|B|}$ .

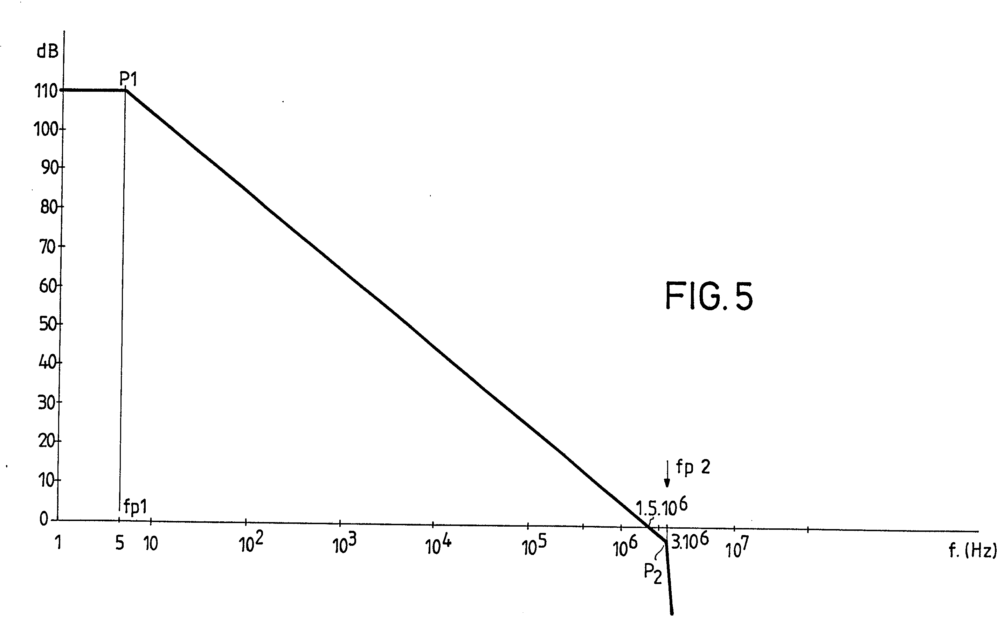

2) The gain magnitude response curve representing $|A|$ in dB in function of the frequency is adequatly represented by using the Bode asymptatic approximations and consists of a number of successive straight line segments each having a slope of -20 dB per decade more than the previous segment, the first segment having a zero slope as shown on Fig. 3. Two succeeding segments intersect at a pole, e.g. Pl, P2 ..., and define corresponding pole frequencies, e.g. fpl, fp2, .... These pole frequencies are determined by the different collector capacities and resistances of the different stages and have a dimension of the reciprocal of the product of a resistance value and a capacity value. More information concerning Bode asymptatic approximations can be found in chapter 15 on pages 275 to 294 of the Schaum's outline series: "Feedback and control systems" edited by Mc Graw-Hill book company. The phase response curve is also adequately represented by straight line segments using Bode approximations. Each pole decreases the slope of the phase shift response by -45° per decade for a decade of frequency above and below the pole frequency so that each pole adds -90° to the overall phase shift as shown on Fig. 4. The phase shift response curves corresponding to the poles P1, P2 and P3 are represented by fal, fa2, and fa3 respectively. The total phase shift is represented by the curve Fa. To examine the stability, the phase margin has to be determined when the open-loop gain magnitude equals the magnitude of the reciprocal of the feedback factor. Also, to assure enough phase margin the magnitude curve of the above reciprocal must intersect the line segment of the open-loop gain magnitude curve having a slope of -20 dB per decade. In the case of a unity gain operational amplifier the feedback factor is 1 so that the second pole P2 must be situated below the 0 dB line. Phase compensation is thus obtained by shifting the first or dominant pole and second pole P1 and P2 of Fig. 3 to the left and to the right respectively. To shift the dominant pole to the left a compensation capacitor CC is used. This feedback capacitor is connected around the emitter follower Q13 and amplifier Q14 (Fig. 1) and provides compensation through Miller-effect multiplication as mentioned earlier. More information concerning this type of compensation can for instance be found on pages 181 to 186 of the earlier mentioned book "Operational amplifiers, design and applications" by J.G. Craeme, G.E. Tobey and L.P. Huelsman. The corresponding dominant pole frequency is a function of the reciprocal of the product of the capacity of this capacitor and the total shunt resistance at the junction point 19. This resistance is a parallel resistance of the following high resistance values : the input resistance

-15-

proper of the stage with transistors Q13, Q14, the resistance of the active load including transistors Q8, Q9 and Q7 and the collector resistances of the cascode transistors Q32, Q30 of the slew-rate circuit. The input resistance proper of the intermediate stage is R6 multiplied by the product of the current gain factors of transistors Q13 and Q14. Cascode configurations are considered on pages 155 to 158 and 412 to 419 of the earlier mentioned book by P.R. Gray and R.G. Meyer. The output impedance of such a stage is B (current gain factor) times that of the common-emitter stage alone.

It has been observed that the second pole P2 is shifted to the right by making the impedance seen at junction point 9 small. This is realized by connecting the series connected diodes Q3, Q5 and Q4, Q6 to the junction point 18 of potentiometer connection including resistors R4 and R5 via the emitter-base circuit of grounded collector transistor Q40 and the common base connection of transistors Q31, Q32.

A typical gain magnitude curve versus the input signal frequency of the operational amplifier which is represented on Fig. 1 and which is used as a voltage follower (unity gain) is shown on Fig. 5. The low frequency gain is 110 dB and the dominant pole P1 has a corresponding frequency of about 5 Hz. The second pole P2 is situated below the O dB line and has a corresponding frequency of 3 MHz. The segment P1 P2 intersects the O dB line at a frequency of 1.5 MHz. The following pole frequencies form a cluster situated in the neighbourhood of the second pole frequency. Since each pole adds - 20 dB per decade to the slope of the following segment the gain magnitude will rapidly decrease. For simplicity reasons only the last segment having a slope of substantially equal to - 100 dB per octave is shown.

The output power stage includes a class B emitter-follower stage

- 16 -

comprising the composite transistor groups Q17, Q18, Q34 and Q35, Q19, the series connected diodes Q15, Q16 which are branched across the base-emitter junctions of transistors Q17 and Q35, low DC power active feedback circuits comprising transistors Q38 and Q39 and protection circuits including transistors Q33 and Q20. Junction point 26 of the above series connection is connected to the collectors of transistors Q14, Q26, to compensation capacitor CC of the intermediate stage, and to terminal D-. Junction point 28 of the series connection is connected to collector of transistor Q27 and to terminal D-. Transistors Q18 and Q19 are double emitter transistors the emitter areas of which have a ratio of 10, the largest area belonging to the emitter connected to the output terminal OUT and to junction point 31 of the base of transistor Q20 and resistors R11 and R3 respectively. The emitters having the largest area will be called principal emitters hereinafter to distinguish them from the secondary emitters having the smallest area. The secondary emitters of the above transistors Q18 and Q19 are connected to the junction points 36 of the base of transistor Q38 and resistor R13 and to junction point 37 of the base of transistor Q39 and resistor R14 respectively. The emitter-collector circuit of transistor Q38 is branched across the base-emitter circuit of transistor Q17. The emitter-collector circuit of transistor Q39 is branched across the series connection of the base-emitter circuit of transistor Q19 and resistor R11 having a small resistance value (7 ohm). Both transistors Q38 and Q39 are bypass transistors used to deviate current from the composite transistor groups and to thus reduce the power dissipation of the output stages as will be shown later. The collector-emitter circuit of transistor Q20 is also branched across the above mentioned series connection whilst its base is connected to the junction point 31 of resistors R3, R11 and principal emitter of transistor Q19. The emitter-collector circuit of transistor Q33 is branched across collector resistor R12 whilst its base is connected to the junction point 35 of

-17,-

collector of transistor Q18 and resistor R10 having a small
resistance value (7 ohms).

As mentioned earlier in the power down state only the output
power stage is connected to the supply voltage VTE and
a constant current supplied by the gating circuit PC (Fig. 6)
enters and leaves the output stage via terminals D+ and D-
respectively. The supply voltage VTES of the input stage
S1 and the intermediate stage S2 as well as the constant current
leaving terminal PD is now interrupted. In this way the power
dissipation of the amplifier is reduced during this power down
period whilst the output stage remains active. This may be
important in certain applications, e.g. in telephony, where
two such amplifiers may be used as line drivers, called tip
and ring amplifier drivers connected to the tip and ring end
of the line loop and where in the on-hook condition (open line
loop) and according to the telephone company specification the
output stages of the amplifiers must be able to transmit the
line loop supply voltages to the tip and ring ends.

To understand the operation of the output stage with bypass
transistors Q38 and Q39 it is first supposed that the bypass
transistors are not present. In this case both  transistors
Q17 and Q35 would be conductive due to the voltage drop across
the series connection diodes Q15 and Q16 being approximately
1.4 Volt and since the line loop is open so that no load is
connected to the amplifier outputs. As a consequence thereof
also transistors Q34, Q18 and Q19 would be conductive. The
bias current in transistors Q17 and Q35 depends on the area
ratios of Q15, Q16, Q17, Q35 as mentioned on page 293 of the
above mentioned book of P.R. Gray and R.G. Meyer. The
collector currents of transistors Q17 and Q18 partly flow
via Q35 and Q19. The currents flowing in the secondary emitters
of transistors Q18 and Q19 are only one tenth of the corresponding currents flowing in their principal emitters and the

-18-

resistances R13 and R14 are so designed that the voltage drop across these resistors is much less than the base-emitter cut-in voltage of transistors Q38 and Q39. Consequently, when transistors Q38 and Q39 are present they will be conductive since the series connection of the base-emitter circuits and resistors R13 and R14 shunt the base-emitter circuits of conductive transistors Q17 and Q19 respectively. Due to transistor Q38 being conductive the major part of the base current which would normally flow in the base-emitter circuit of transistor Q17 in the absence of transistor Q38 is now deviated via the emitter-collector circuit of transistor Q38. This deviated current returns to the gating circuit PC (Fig. 6) via base-emitter of transistor Q35 and terminal D-. In a similar way most of the base current of transistor Q19 is deviated via transistor Q39. In this way the power dissipation of the output stage is reduced due to the reduced activity of transistors Q34, Q18 and Q19. Indeed, if the above bypass transistors were not present and although the load is disconnected current may flow from ground to VTE through the output stage.

In the power on stage the line loop (load) is closed and all the stages are supplied with supply voltages and the consant current entering and leaving the operational amplifier via terminals D+ and D- is interrupted. However, the gating circuit PC (Fig. 6) is now drawing a constant current from the operational amplifier via terminal PD. This current generates constant currents in the mirror circuit including transistors Q25, Q26, Q27, Q28. The constant current flowing in branch b divides between the series connected diodes Q15, Q16 and branch b'. When the voltage of junction point 26 changes due to a signal being applied to one of the input terminals, the emitters of transistors Q17 or Q35 will follow depending on whether the voltage increases or decreases respectively. Indeed, due to the voltage drop across the series connected diodes Q15, Q16 remaining constant, the

-19-

base-emitter voltage of transistor Q17 increases slightly whilst the base-emitter voltage of transistor Q35 decreases with the same amount when the voltage of junction point 26 increases. Consequently, the emitter of transistor Q17 will follow the voltage increase at junction point 28 and the current through the load connected to the output OUT increases whilst transistor Q35 and consequently also Q19 will carry a very small current. Due to transistor Q18 increasing its emitter current, the voltage drop across R13 increases beyond the base-emitter cut-in voltage of transistor Q38 which is then blocked. Similarly, when the voltage of junction point 26 decreases transistors Q35, Q19 and Q39 are rendered conductive and blocked respectively.

It should be noted that transistor Q33 and base resistance R10 and transistor Q20 and base resistance R11 form protection circuits to protect the output stage against a current overload. Indeed, when the output current exceeds 100 mA with R10 and R11 having a value of 7 ohms, transistors Q33 or transistor Q20 will saturate so that transistor Q34 or Q19 is blocked respectively.

Generally, the described amplifier is used with a feedback loop coupled between the output terminal OUT and one of the input terminals. An important case is the voltage follower wherein the output is connected with the inverting (-) input terminal and the signal is applied to the non inverting (+) input terminal. Such an amplifier has an application in telephony where it may be used as a line driver op amp connected in a line loop.

In Fig. 6 are shown two such amplifiers OA1 and OA2 used as tip and ring line driver operational amplifiers, the tip and ring outputs Ti en Ri of which are connected to a lineloop L with subset S via lineloop resistors RL1 and RL2 respectively.

The amplifiers OA1 and OA2 form part of a line circuit part which is shown on Figures 6 and 7. These figures have to be put side by side with Fig. 7 on the right side. This line circuit further includes control and filtering circuits CF and CF' (Fig. 7) used as a noiseless battery reversal circuit, a battery reference circuit BR (Fig. 7) to supply battery reference voltages, a line feed driver LFD (Fig. 7) used to provide a variable supply voltage VTE to the gating circuit PC (Fig. 6) under the control of a line feed and supervision circuit LFS. This LFS, which is described in detail in the US patent application serial number 303 457 first filed on September 18, 1981---------------------------------------------- senses the voltage drop across lineloop resistors RL1 and RL2, via wires s1 s'1, s2, s'2 and generates a voltage at its output terminals S1, S'1 (S1 earthed) in function of the line length. This voltage is supplied to the line feed driver which generates a supply voltage VTE which is applied to the gating circuit PC and operational amplifiers OA1, OA2. For line lengths having a line resistance smaller than a predetermined value, e.g. 800 ohms, VTE is proportional to the line length. For larger line length VTE may be constant. The operation of the gating circuit PC and the line feed driver LFD will be described later.

The non inverting inputs (+) of the amplifiers OA1, OA2 are connected to the control and filtering circuits CF, CF' and battery reference circuit BR which are described in detail in the Belgian patent N° 890 401 . The line feed driver includes an operational amplifier OA3, Schmitt trigger SM, Darlington circuit including transistors T20, T21, the common anodes of which are coupled to external voltage sources VX (-30 Volts) and -V (-48 Volts) via diode D10 and the collector-emitter circuit of transistor T22 respectively. The base of this transistor is connected to the output of Schmitt trigger SM one of the inputs of which is connected to VX.  The other input is connected to the output of operational amplifier OA3 and to the base of transistor T20.  The non inverting input (+) of OA3 is connected to -V, terminal S'1 and junction point of switches SW1, SW2 via resistors R25, R26 and R27 respectively.  The inverting input (-) of OA3 is connected to -V, terminal S'1 and junction point of switches SW'1, SW'2 via resistors R'25, R'26 and R'27 respectively. The emitter of transistor T21 is connected to terminal VTE of the gating circuit PC.  Resistors R25, R'25, R27, R'27 have identical values.  Also, resistors R26 and R'26 have identical values but different from the proceding ones.  The feedback circuit of amplifier OA3 includes the series connection of the base-emitter circuits of transistors T20, T21, one of Zener diodes Z'1, Z'2 depending on whether switch SW'1 or SW'2 is closed respectively and resistor R'27.  It can easily be shown that due to the symmetrical resistor configuration at the inverting and non-inverting input terminals the output signal is equal to the product of the closed loop amplification factor ($\frac{R27}{R26}$ ) and the difference of the input signals applied to the input terminals.  This means that a potential difference may exist between the earth of amplifier OA3 and the earth of LFS.--------------------------Indeed, this potential difference will not influence the above input signal difference.  The earth of the LFS which contain low voltage circuits is connected to an electronic ground indicated by the earth symbol connected to terminal S1 whilst the earth of the other circuits (LFD, BR, CF, CF, PC, OA1, OA2) which are high voltage circuits ( 48 volts) is connected to the battery ground and these grounds are directly or indirectly interconnected.  Between these grounds a potential difference may arise due to high currents flowing in the ground connection when a short circuit occurs between the electronic ground and the negative battery supply voltage for. instance.

The line feed driver LFD operates as follows.  The operational

-22-

amplifier OA3 amplifies (20 times) the voltage of the signal supplied by LFS to the input terminals, it being supposed that the voltage at the non-inverting terminal (+) is negative with respect to the voltage applied at the inverting terminal (-). The amplified voltage is supplied via emitter followers T20, T21 to PC and the operational amplifiers OA1, OA2. Current is flowing in the different circuits (OA1, OA2, PC, CF, BR) from earth to the negative battery pole (-V) via transistors T21, T20 and transistor T22 which is conductive as long as the negative voltage at the output of operational amplifier OA3 is smaller than VX + DVX (VX is of the order of -30 Volt), wherein DVX is the hysteresis voltage difference of the Schmitt trigger. Indeed, when this is the case, the output voltage of the Schmitt trigger is larger than -V so that base current is able to flow in transistor T22. In this case diode D10 is blocked. However, when the output voltage of the operational amplifier reaches -VX + DVX the Schmitt trigger output triggers to -V so that transistor T22 is blocked but diode D10 is rendered conductive at this moment. Current now flows to -V via transistors T20, T21 and conductive diode D10.

It should be noted that by connecting the non-inverting and inverting inputs of operational amplifier OA3 across resistance R1 via the resistors R27 and R'27 respectively the line voltage change due to the switching of different Zenerdiodes pairs (Z1, Z'1; Z2, Z'2) is taken into account.

Tip and ring terminals PDT, PDR, DT+, DT-, DR+, DR- of the gating circuit PC are connected to the corresponding terminals PD, D+ and D- of the operational amplifiers OA1 and OA2 respectively.

The gating circuit PC includes a first current source including transistor T8 and a mirror circuit including transistors T4, T5, T6, T7 coupled to mirror circuit including transistors T14, T15, T16 and a second current source including mirror circuit with transistors T1, T2, T3 coupled to mirror circuit including transistors T11 and T12. The mirror circuits of the first current source are intercoupled by means of transistor T6 and collector-to-base connected transistor T14. The mirror circuits of the second current source are intercoupled by means of transistors T3, diode D3, D4 and collector-to-base connected transistor T12. The collectors of transistors T4 and T2 of the respective first and second current sources are intercoupled and are connected to the negative battery pole -V via resistor R22. Also, the second current source includes the series connected transistors T9 and T10 the bases of which are connected to junction point of the series connected diodes D1, D2 and resistor R22 and to the junction point of the series connected diodes D3, D4 and collector of transistor T3 respectively. When terminal PWD is biased with a sufficiently low negative voltage value to make transistors T7 and T8 conductive the current in the collector branches of transistors T4, T5, T6, T7 is then equal to 0.7 Volt divided by the resistance value of resistor R21, it being supposed that the circuit shown on Fig. 6 is an integrated circuit with silicium components. The collectors of transistors T15 and T16 are connected to PDT and PDR respectively. When the first current source is thus made active the second current source is deactivated. Indeed the resistance value of resistor R22 is so chosen that the voltage drop across this resistor is such that a voltage drop of less than 3 x 0.7 Volt is left across the series connection of diodes D1, D2 and base-emitter of T2 so that the transistors T1, T2, T3 are non conductive. Consequently, also transistors T11 and T12 of the second current source are blocked so that this second current source is rendered inactive. Due to this transistor T13 is rendered conductive so that voltage VTE is transmitted to terminal VTES via the collector-emitter circuit of T13.

-24-

On the contrary, when terminal PWD is earthed the first current source is rendered inactive and the second current source is rendered active. The current flowing in the branch including the series connection of resistor R22, diodes D1, D2 and transistor T2 is mirrored in the different branches of the mirror circuits of this second current source and is determined by the negative supply voltage value V- and the value of resistor R22. A constant current is thus able to flow to amplifiers OA1 and OA2 between ground and the voltage VTE in the following circuit :

emitter-collector circuit of transistor T1, terminal DT+, terminal D+ of amplifier OA1, output stage of OA1, terminal D-, terminal DT-, emitter-collector circuits of transistors T9 and T10, terminals DR+, D+ and D- of operational amplifier OA2, terminal DR- and collector-emitter circuit of transistor T11. In this way the same constant current flows in both amplifiers OA1 and OA2. It should be remarked that the necessary bias for transistors T9 and T10 is realized by means of diodes D1, D2 and D3, D4 respectively. It should be remarked that the voltage VTE is not transmitted to terminal VTES since transistor T13 is blocked when the second current source is active.

While the principles of the invention have been described above in connection with specific apparatus, it is to be clearly understood that this description is made only by way of example and not as a limitation on the scope of the invention.

-25-

## Claims

1. Differential amplifier circuit, e.g. an operational amplifier, including a differential-to-single-ended amplification stage comprising cross-coupled first and second amplification circuits, characterized in that said cross-coupled first (Q3, Q5, Q29, Q31) and second (Q4, Q6, Q30, Q32) amplification circuits include first (Q29, Q31) and second (Q30, Q32) cascode circuits respectively.

2. Differential amplifier circuit according to claim 1, characterized in that said differential-to-single-ended amplification stage has a low input impedance.

3. Differential amplifier circuit according to claim 1, characterized in that said differential-to-single-ended amplification stage further includes a differential-to-single ended conversion high impedance stage coupled in cascade with said amplification circuits, each of said first and second cascode circuits comprising an input first transistor (Q29, Q30) and an output second transistor (Q31, Q32) the bases of which are interconnected via a first diode (Q5; Q6) and the bases of said second transistors being moreover interconnected and coupled to a potentiometer circuit (R4, R5) via the emitter-base circuit of a grounded collector third transistor (Q40), the collector (19) of one (Q32) of said second transistors constituting an output terminal (19) of said differential-to-

-26-

single-ended amplification stage which has first (9) and second (10) input terminals constituted by input terminals (9, 10) of said first and second amplification circuits respectively, and that said first (9) and second (10) input terminals are coupled, on the one hand to the bases of said first transistor (Q29; Q30) in said first and second amplification circuits via second (Q3) and third (Q4) diodes respectively and on the other hand to the emitters of said first transistors (Q29; Q30) in said second and first amplification circuits respectively.

4. Differential amplifier circuit according to claim 3, characterized in that it further includes a differential input stage (Q1, Q2) with a non-inverting input (3) and an inverting input (4) and with first and second output branches coupled to said first (9) and second (10) input terminals of said differential-to-single-ended amplification stage via transistor current mirror circuits (Q21, Q22; Q23, Q24).

5. Differential amplifier circuit according to claim 3, characterized in that it further includes an intermediate amplification stage and an class B emitter follower output amplification stage which are coupled in cascade between said output terminal (19) of said differential-to-single-ended amplification stage and an electric load (L).

6. Power amplifier circuit connected in class B emitter follower configuration and having a single AC/DC signal input terminal and a common terminal which is coupled to a load, said power amplifier circuit being fed from a DC voltage source and including two emitter follower amplification circuits each branched between said common terminal and a distinct pole of said DC voltage source, individual input terminals of said amplification circuits being intercoupled by two series connected fourth diodes fed from a DC current

-27-

source and one of said individual input terminals constituting said single input terminal, each of said amplification circuits including an output fourth transistor and the collector-to-emitter paths of said output fourth transistors being interconnected in series and connected to said common terminal, characterized in that in each of said emitter follower amplification circuits (Q17, Q18, Q33, Q34, Q38; Q19, Q20, Q35, Q39) an output signal of said output fourth transistor (Q18; Q19) controls an associated individual current deviation means (Q38; Q39) in such a way that when said load has a lower impedance value no current is deviated from said individual input terminal, whereas when said load has a higher impedance value current is deviated from said individual input terminal.

7. Power amplifier circuit according to claim 6, characterized in that each of said output fourth transistors (Q18; Q19) has a second emitter on which said output signal is generated and which is coupled to the base electrode (36, 37) of a fifth transistor (Q38; Q39) which constitutes said current deviation means and that in a first of said amplification circuits the emitter-collector path of said fifth transistor (Q38) is connected between said individual input terminal of this first amplification circuit and said common terminal, whilst in a second of said amplification circuits the emitter-collector path of said fifth transistor (Q39) is connected between the base of said fourth transistor (Q19) of said second amplification circuit and a terminal (VTE) of said DC voltage source.

8. Power amplifier circuit according to claim 7, characterized in that the area of said first mentioned emitter is much larger than that of said second emitter.

9. Power amplifier circuit according to claim 7, characterized in that said second emitter is connected to collector electrode of said fifth transistor (Q38; Q39) via a first resistance (R13; R14).

10. Differential amplifier circuit according to claim 5, characterized in that said class B emitter follower output amplification stage is a power amplifier circuit as per any of the claims 6 to 9.

11. Differential amplifier circuit according to claim 10, characterized in that said input, differential-to-single-ended and intermediate amplification stages are able to be fed from the first mentioned DC voltage source (LFD, ground, VTE) and from a second DC current source (ground, PD, VTE), whereas said output amplification stage is continuously fed from said first mentioned DC voltage source (LFD) and able to be fed from said first mentioned current source (D+, D-) or from said second current source, and that a gating circuit (Fig. 6) is provided in order when the impedance of said electric load has said higher value to disconnect said first mentioned DC voltage source and said second current source from said input, differential-to-single-ended and intermediate amplification stages and to connect said first current source to said output amplification stage and in order when the impedance of said electric load has said lower value to connect said second DC voltage source and said second current source to all the amplification stages and to disconnect said first mentioned current source from said output amplification stage.

12. Gating circuit having a control terminal to which a control signal provided by a control system is applied, characterized in that it includes a third (T4-T8, T14-T16) and a fourth (T1-T3, T9-T11) DC current sources which are both fed from a first DC voltage source (LFD; ground, VTE), said third current source being controlled by said control signal (PWD) and said third and fourth current sources being intercoupled in such a way that for one condition of said control signal said third DC current source is operated and thereby inhibits the operation of said fourth current source, whereas for the other condition of said control signal said third current source is not operated and said fourth current source is operated.

13. Gating circuit according to claim 12, characterized in that said third and fourth DC current sources each include a plurality of current mirror transistors, output electrodes of current mirror sixth transistors (T4, T2) of said third and fourth current sources being coupled to a fixed DC potential via common second resistance (R22) in such a way that when said third DC current source is operated the voltage drop then produced over said second resistance inhibits the operation of said fourth current source.

14. Gating circuit according to claim 12, characterized in that said fourth current source includes two pairs (T1, T9; T10, T11) of input (T9, T11) and output (T1, T10) seventh transistors providing connection terminals of two first DC current sources (DT+, DT- ; DR+, DR-) respectively, the bases of each pair of said input and output seventh transistors being intercoupled via clamping fourth diodes (D1, D2; D3, D4).

15. Gating circuit according to claims 13 and 14, characterized in that the base of said input seventh transistor (T9) of one of said pairs is connected to the junction of said second resistance (R22) and said output electrode of said sixth transistor (T4) of said third DC current source.

16. Gating circuit according to claim 12, characterized in that said third DC current source includes an eigth transistor (T13) which is operated when said third DC current source is operated and then connects an input terminal (VTE) of said first DC

-30-

voltage source (LFD) with a DC voltage output terminal (VTES), and that said third current source also has two input ninth transistors (T15, T16) providing connection terminals of second DC current sources (ground, PDT, VTE; ground, PDR, VTE).

17. Differential amplifier circuit according to claim 11, characterized in that said gating circuit is as claimed in claims 14 and 16, the connection terminals of one of said two first DC current sources being coupled to said first and second input terminals of said output amplification stage, the connection terminal of one of said second DC current sources being connected to said input, differential-to-single-ended and intermediate amplification stages, and said DC voltage output terminal (VTES) being continuously connected to said input, differential-to-single-ended and intermediate amplification stages, whilst said output amplification stage is continuously connected to said output terminal (VTE) of said first DC voltage source.

18. Telecommunication line circuit including two line driver feedback amplifier circuits which are connected to first and second conductors of a telecommunication line respectively, characterized in that each of said line driver feedback amplifier circuits is fed from a first DC voltage source (LFD) providing a variable first DC supply voltage (VTE) which is function of the length of said line (L).

19. Telecommunication line circuit according to claim 18, characterized in that said first DC voltage source has an output coupled to said line driver amplifier circuits (OA1, OA2) and an input coupled to an output (S1, S'1) of a line loop current control circuit (LFS) having two inputs (s1, s'1; s2, s'2) across each of which a respective one of two line loop third resistors (RL1; RL2) is coupled, said line loop current control circuit (LFS) providing at its output a

variable DC output voltage which is function of said line length.

20. Telecommunication line circuit according to claim 19, characterized in that said first DC voltage source (LFD) includes an operational amplifier circuit (OA3) the non-inverting and inverting inputs of which are coupled on the one hand to the terminals of said output (S1, S'1) of said line current control circuit (LFS) and on the other hand to symmetrical points of a potentiometer circuit (Z1, Z2; R1; Z'1, Z'2) branched across said variable first DC supply voltage (VTE), and that said symmetrical points are coupled to the non-inverting inputs (3) of input stages included in said line driver amplifier circuits (OA1, OA2), the voltages at said symmetrical points differing from the feed voltages of said potentiometer circuit by equal predetermined but adjustable voltage values.

21. Telecommunication line circuit according to claim 18, characterized in that said first DC voltage source (LFD) includes a power stage (SM, T20-T22, D10) the output of which is the output of said first DC voltage source (LFD), said power stage including means for regulating the electric power consumption of said first DC voltage source in function of said line length.

22. Telecommunication line circuit according to claims 20 and 21, characterized in that said power stage includes an emitter follower amplification circuit (T20, T21) and a Schmitt trigger circuit (SM), said emitter follower amplification circuit having an input connected to an output of said operational amplifier circuit (OA3) and being able to be fed either from a second DC supply voltage (-V) via a first switch (T22) or from a third DC supply voltage (VX) via a second switch (D10), and said Schmitt trigger circuit (SM)

-32-

having inputs connected to said output of said operational amplifier circuit (OA3) and to said third DC voltage (VX) and an output of controlling said first switch (T22) in such a way that when the voltage at said output of said operational amplifier is lower than said third DC supply voltage said first switch (T22) is operated and inhibits said second switch (D10), whereas when it is larger said first switch is inhibited and said second switch is operated.

23. Telecommunication line circuit including two line driver feedback amplifier circuits which are connected to first and second conductors of a telecommunication line respectively, characterized in that said line driver feedback amplifier circuits are constituted by differential amplifier circuits, each according to claim 17 and each coupled to respective ones of said two first current sources and said two second current sources.

24. Telecommunication line circuit according to claim 23, characterized in that said first DC voltage source is as per any of the claims 18 to 22.

FIG.1

0078347

FIG.2

FIG.3

FIG.4

FIG.5

0078347

FIG.6

0.078347

-4/5-

0078347

FIG.7

European Patent
Office

**EUROPEAN SEARCH REPORT**

Application number

EP 81 20 1204

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US - A - 3 843 934 (J.N. GILES)<br>* Figures 2,3; column 2, lines 22-41; column 3, lines 7-29 * | 1 | H 03 F 3/45 |
| A | US - A - 3 668 538 (W.E. HEARN)<br>* Figures 1-4; column 2, lines 11-23 * | 1,2 | |
| A | US - A - 3 868 586 (H.W. KORB)<br>* Figure ; column 3, lines 10-48; column 4, lines 9-43 * | 1 | |
| A | MICROELCTRONICS AND RELIABILITY, vol. 13, no. 5, October 1974 Pergamon Press GB C.R. AVERY: "Mixed-discipline monolithic integrated circuits - bipolar, MOS and COS/MOS technologies anf future trends", pages 349-361<br>* Figures 10,11,17; page 354, right-hand column, lines 2-22 * | 3,4 | **TECHNICAL FIELDS SEARCHED (Int. Cl. ³)**<br><br>H 03 F |
| A | US - A - 3 995 229 (R.A. STEHLEN)<br>* Figure; column 2, lines 27-53 * | 3-5 | |

~~The present search report has been drawn up for all claims~~

| Place of search | Date of completion of the search | Examiner |
|---|---|---|
| The Hague | 23-06-1982 | TYBERGIEN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent
Office

## CLAIMS INCURRING FEES

The present European patent application comprised at the time of filing more than ten claims.

☐ All claims fees have been paid within the prescribed time limit. The present European search report has been drawn up for all claims.

☐ Only part of the claims fees have been paid within the prescribed time limit. The present European search report has been drawn up for the first ten claims and for those claims for which claims fees have been paid.

namely claims:

☐ No claims fees have been paid within the prescribed time limit. The present European search report has been drawn up for the first ten claims.

## ☒ LACK OF UNITY OF INVENTION

The Search Division considers that the present European patent application does not comply with the requirement of unity of invention and relates to several inventions or groups of inventions,
namely:

1) Claims 1-5,10,11,17: Differential amplifier with high slew rate
2) Claims 6-9: Power amplifier with power dissipation reducing means
3) Claims 12-16: Gating circuit
4) Claims 18-24: Telecommunication line circuit with power consumption reducing means.

☐ All further search fees have been paid within the fixed time limit. The present European search report has been drawn up for all claims.

☐ Only part of the further search fees have been paid within the fixed time limit. The present European search report has been drawn up for those parts of the European patent application which relate to the inventions in respect of which search fees have been paid.

namely claims:

☒ None of the further search fees has been paid within the fixed time limit. The present European search report has been drawn up for those parts of the European patent application which relate to the invention first mentioned in the claims.

namely claims: 1-5, 10, 11, 17